# EUROPEAN PATENT SPECIFICATION

(11) **EP 1 725 978 B1**
(45) Date of publication and mention of the grant of the patent: **16.09.2009**
(21) Application number: 05718047.3
(22) Date of filing: 16.03.2005
(51) Int. Cl.: G06K 19/077, H05K 3/02, G08B 13/24, H01Q 1/22

(54) **POLYMERIC FILM SUBSTRATE FOR USE IN RADIO-FREQUENCY RESPONSIVE TAGS**
POLYMER-FILMSUBSTRAT ZUR VERWENDUNG IN AUF HOCHFREQUENZ ANSPRECHENDEN ETIKETTEN
SUBSTRAT EN FILM POLYMERE UTILISE DANS DES ETIQUETTES SENSIBLES AUX RADIOFREQUENCES

(30) Priority: 16.03.2004 GB 0405883
(43) Date of publication of application: 29.11.2006
(73) Proprietor: Dupont Teijin Films U.S. Limited Partnership, Chester VA 23836 (US)
(72) Inventor: EVANS, Ken, Stockton-on-Tees TS15 9UN (GB); SANKEY, Stephen William, Northallerton DL6 2HR (GB); TURNER, Dave, Shiremoor,Newcastle-upon-Tyne NE27 0BD (GB); POLACK, Natalie, Stockton-on-Tees TS16 0AJ (GB); KOSUGE, Masahiko, Midlothian, VA 23112 (US); NUGARA, Peter Neil, Richmond, VA 23236 (US)
(74) Representative: Cockerton, Bruce Roger
(86) International application number: PCT/GB2005/000999
(87) International publication number: WO 2005/091213

(56) References cited:
- WO-A-03/028416

## Description

This invention relates to a composite film useful as a substrate for radio-frequency responsive tags, including radio-frequency tags (RF. tags) used for electronic article surveillance and radio-frequency identification tags (RFID tags), and to the composite structure comprising the substrate and the radio-frequency functional components, and to a process for the production thereof.

Radio-frequency (RF) communication systems are finding valuable uses in anti-theft, anti-counterfeit and authentication security devices, as well as in control systems for the storage, movement, maintenance, tracking and sorting of goods or stock. Specific applications include washable RF-responsive tags which can be sewn into clothing; RF-responsive tags in smart cards and personal identification cards; RF-responsive tags in medical equipment and supplies; RF-responsive tags in smart labels for logistics and supply chain applications; and RF-responsive tags for embedding into bank notes. RF-responsive devices can be used to carry unique data, for instance: (i) identifier data, in which a numeric or alphanumeric string is stored for identification purposes or as an access key to data stored elsewhere in a computer or information management system; and (ii) portable data files, in which information can be organised, for communication or as a means of initiating actions without recourse to, or in combination with, data stored elsewhere.

The technology uses radio-waves to communicate with an RF-responsive device without the requirement of direct contact or line-of-sight. The RF-responsive device functions by retransmitting or by reflecting or otherwise disrupting a radio frequency signal. There are two main classes of RF-responsive tags.

The first class, referred to herein as "radio-frequency tags" (RF tags), are primarily used for electronic article surveillance (EAS), and typically as anti-theft devices. When the tags are passed through a surveillance zone, which is created by a transmitter sending out defined frequencies to a receiver, the tags create a disturbance in the surveillance field which is detected by the receiver. These types of RF tags typically comprise as essential components a substrate and an antenna such as a metal pattern or coil.

The second class of RF-responsive tags, referred to herein as "radio-frequency identification tags" (RFID tags), comprise not only an antenna and a substrate but also a data-carrying means which is electronically programmable with unique information. Thus, the tag may comprise a microchip or integrated circuit. There are also applications using chip-less tags, and such tags may comprise data-carrying electronic components such as thin-film transistors (TFTs), electromagnetic micro-wires having controlled surface vs bulk characteristics designed to maximise the so-called Barkhausen electromagnetic effect, and components using programmable magnetic resonance technology (PMR) in an acoustic-magnetic detection system.

A typical radio-frequency identification system comprises an antenna; a transceiver (with decoder); and a transponder (the RF-responsive tag). The antenna emits radio signals to activate the tag and read and/or write data to it. The transceiver controls data acquisition and communication, and typically interfaces with an information management system. The antenna may be packaged with the transceiver and decoder to become a reader, which can be configured either as a handheld or a fixed-mount device. The reader emits radio waves in ranges of anywhere from a few centimetres to 30 metres or more, depending upon its power output and the radio frequency used. When the tag passes through the electromagnetic zone, it detects the reader's activation signal. The reader decodes the data encoded in the tag's integrated circuit and the data is passed to the host computer (information management system) for processing.

Radio-frequency identification systems operate at various frequency ranges. Low-frequency (typically 30 KHz to 500 KHz) systems have short reading ranges and lower system costs, and are most often used for security access and local asset tracking applications. High-frequency (typically 13.56 MHz) systems are often used in smart cards, libraries, laundries, and track and trace applications. Ultra-high frequency (typically 168-950 MHz) and microwave frequency (> 2.4 GHz) offer longer read ranges (greater than 30 metres) and higher reading speeds and are of growing interest in some applications.

RF-responsive tags may be categorized as either active or passive. Active tags are powered by an internal battery and are typically read/write. In a typical read/write work-in-process system, a tag might give a machine a set of instructions, and the machine would then report its performance to the tag, the encoded data then becoming part of the tagged part's history. The battery-supplied power of an active tag generally gives it a longer read range, but such tags are of greater size, greater cost, and have a limited operational life. Passive tags operate without an internal power source, i.e. they have no battery, and obtain operating power from the initial radio signal to transmit a response. Passive tags are consequently much lighter than active tags, less expensive, and offer a virtually unlimited operational lifetime, although they have shorter read ranges and require a higher-powered reader. Read-only tags are typically passive and are programmed with a unique set of data (usually 32 to 256 bits on a chip tag, and less on a chip-less tag) that cannot be modified. Read-only tags most often operate in combination with a database containing modifiable product-specific information, in the same way as a barcode.

An RF-responsive tag may comprise analogue circuitry (including the antenna, and for instance a capacitor) for data transfer and power supply, and in chip tags, a digital low-power integrated circuit (or microchip), and optionally a battery. Typical transponders are described in, for example, US Patents 5,541,399, 4,730,188 and 4,598,276. In chip tags, the microprocessor interfaces with the transponder memory, which may comprise read-only (ROM), random access (RAM) and non-volatile programmable memory (typically electrically erasable programmable read only memory (EEPROM)) for data storage depending upon the type and sophistication of the device. ROM-based memory is used to accommodate security data and the transponder operating system instructions which, in conjunction the processor or processing logic, deals with the internal functions such as response delay timing, data flow control and power supply switching. RAM-based memory is used to facilitate temporary data storage during transponder interrogation and response. Non-volatile programmable memory is used to store the transponder data and ensures that data are retained when the device is in a quiescent or power-saving state. The transponder antenna is the means by which the device senses the interrogating field (and, where appropriate, the programming field) and also serves as the means of transmitting the transponder response to interrogation. The antenna typically consists of a coil of wire or a conductive pattern, typically aluminium, copper or silver, disposed on a dielectric or insulating substrate. The antenna may be formed in a number of ways, for instance by stamping or embossing the metal component onto the substrate; by etching the conductive pattern in a foil substrate; by using conductive paints, inks or pastes; by electroless or electroplating onto a metallic seeding ink (for instance in accordance with the technology of RT circuits); or by bonding pre-cut patterns onto the substrate. In one process, an antenna is formed by screen-printing a substrate with silver ink, and optionally copper-plating over the ink. Typically, an antenna is formed by etching, or printing a silver ink. Interface circuitry between antenna and microchip directs and accommodates the interrogation field energy for powering purposes in passive transponders and triggering of the transponder response. One problem with the use of conventional substrates, particularly those used for the manufacture of RF-responsive tags in which the conductive pattern of the antenna is formed using conductive inks or pastes, has been flex-cracking of the conductive pattern (which can adversely affect the range and functioning of the antenna, as well as the adhesion strength to the conductive pattern of other components of the RF-response tag which are mounted over the conductive pattern).

WO 03/028416 A discloses a process for producing a structured metal layer on a substrate body, in which a metal foil or a metal layer is applied to the entire surface of a substrate body made from a plastics material and is pressed onto the substrate body with the aid of a structured, heated ram and fixed by a subsequent setting of the substrate body. As used herein, the term "RF-responsive tag" refers to an article which reacts to a radio-frequency signal and which comprises as essential functional components a substrate and an antenna, and optionally further comprises a battery, and/or a data carrying means such as an integrated circuit. The term "RF-responsive tag" includes both RF tags and RFID tags, as defined hereinabove. As used herein the term "antenna" refers to a metal pattern or coil receptive to radio-frequencies.

Previously, RF-responsive tags have been manufactured by providing a polymeric film substrate, and adhering one or more of the transponder components thereto, including the antenna component, by using a layer of adhesive. The adhesive layer is typically coated off-line, i.e. in a process step which is separate from the step of manufacture of the polymeric film substrate and which involves the use of hazardous and environmentally unacceptable solvents. The adhesive layer is typically 20 to 30 microns thick in the prior art RF-responsive tags. It is an object of this invention to provide a more economical and thinner RF-responsive tag, which may also be flexible. It is also an object of this invention to provide good delamination resistance between the polymeric film substrate and the antenna component. It is also an object of this invention to provide such an RF-responsive tag (or a composite film comprising a substrate and the conductive pattern suitable as a precursor in the manufacture of the RF-responsive tag) which exhibits reduced flex-cracking of the conductive pattern, particularly wherein the conductive pattern is formed using conductive inks or pastes.

According to the present invention, there is provided an RF-responsive tag as defined in claim 1, and optionally a data-carrying means in electrical communication with the antenna.

The conductive material of the antenna is preferably metallic, and is preferably selected from metals such as copper, aluminium, silver, gold, zinc, nickel and tin, preferably copper, aluminium, silver and gold, preferably aluminium and copper, and preferably copper.

The RF-responsive tag of the present invention is advantageous in that it dispenses with the need for a layer of adhesive between the antenna and the substrate, and is therefore more economical, efficient and environmentally acceptable to produce, and the RF-responsive tag may also be made thinner.

The substrate is a self-supporting film or sheet by which is meant a film or sheet capable of independent existence in the absence of a supporting base. The substrate is biaxially oriented. The substrate comprises a polyester film. Linear polyesters are preferred. Suitable polyesters include those derived from one or more dicarboxylic acids, such as terephthalic acid, isophthalic acid, phthalic acid, 1,4-, 2,5-, 2,6- or 2,7-naphthalenedicarboxylic acid, succinic acid, sebacic acid, adipic acid, azelaic acid, 1,10-decanedicarboxylic acid, 4,4'-diphenyldicarboxylic acid, hexahydro-terephthalic acid or 1;2-bis-p-carboxyphenoxyethane (optionally with a monocarboxylic acid, such as pivalic acid), and from one or more glycols, particularly an aliphatic or cycloaliphatic glycol, such as ethylene glycol, 1,3-propanediol, 1,4-butanediol, neopentyl glycol, diethylene glycol and 1,4-cyclohexanedimethanol. An aliphatic glycol is preferred. A preferred substrate polyester is selected from polyethylene terephthalate (PET) and polyethylene naphthalate (PEN). PET or a copolyester thereof is particularly preferred.

The substrate layer is a multilayer substrate, the functional requirement being that it is heat-sealable to the conductive material of the antenna. As used herein, the term "heat-sealing substrate" therefore refers to a substrate layer which has been heat-sealed to the conductive material of the antenna. Similarly, the term "RF-responsive tag comprising a heat-sealing substrate and an antenna" refers to an RF-responsive tag in which an adhesive heat-seal bond has been formed between a heat-sealable substrate and the antenna. Similarly, the term "composite film comprising a layer of conductive material and a heat-seating substrate" refers to a composite film in which a heat-seal bond has been formed between the heat-sealable substrate and the conductive material.

The heat-sealable polymeric material should soften to a sufficient extent that its viscosity becomes low enough to allow adequate wetting for it to adhere to the surface to which it is being bonded. The heat-sealable polymer is a copolyester derived from ethylene glycol, terephthalic acid and isophthalic acid, or from terephthalic acid, ethylene glycol and 1,4-cyclohexanedimethanol. The substrate comprises more than one layer, provided that at least one of the layers (i.e. the layer adjacent the metallic antenna layer) is heat-sealable. In this embodiment, the layer(s) other than the heat-sealable layer adjacent the metallic antenna layer is/are referred to herein as "base layer(s)" of the substrate layer.

The base layer is a layer compatible with the heat-sealable polymer, in order to provide adequate interlayer adhesion. The base layer is PET.

In one preferred embodiment, hereinafter referred to as Embodiment B1, the heat-sealable layer comprises a copolyester derived from ethylene glycol, terephthalic acid and isophthalic acid. The preferred molar ratios of the terephthalic acid component to the isophthalic acid component are in the range of from 50:50 to 90:10, preferably in the range from 65:35 to 85:15. In a preferred embodiment, this copolyester is a copolyester of ethylene glycol with about 82 mole % terephthalate and about 18 mole % isophthalate.

In an alternative embodiment, hereinafter referred to as Embodiment B3, the heat-sealable layer comprises a copolyester derived from terephthalic acid ethylene glycol and 1,4-cyclohexanedimethanol. The preferred molar ratios of the 1,4-cyclohexanedimethanol to the ethylene glycol are in the range from 10:90 to 60:40, preferably in the range from 20:80 to 40:60, and more preferably from 30:70 to 35:65. In a preferred embodiment this copolyester is a copolyester of terephthalic acid with about 33 mole % 1,4-cyclohexane dimethanol and about 67 mole % ethylene glycol. An example of such a polymer is PETG^{™}6763 (Eastman) which comprises a copolyester of terephthalic acid, about 33% 1,4-cyclohexane dimethanol and about 67% ethylene glycol and which is always amorphous.

Formation of the copolyesters is conveniently effected in known manner by condensation, or ester-interchange, at temperatures generally up to 275°C.

The thickness of the heat-sealable layer is generally between about 1 and 30%, preferably about 10 and 20% of the thickness of the substrate. The heat-sealable layer may have a thickness of up to about 25µm, more preferably up to about 20µm, more preferably up to about 15µm, more preferably up to about 10µm, more preferably between about 0.5 and 6µm, and more preferably between about 0.5 and 4µm. The overall thickness of the substrate is preferably up to about 350 µm, more preferably up to about 100 µm, more preferably up to about 75 µm, more preferably between about 12 and 100 µm, and more preferably between about 20 and 75 µm.

Preferably, the substrate exhibits a heat-seal strength to itself of at least 300 g/25mm², preferably from about 400 g/25mm² to about 1000 g/25mm². and more preferably from about 500 to about 850 g/25mm².

Preferably, the substrate exhibits a heat-seal strength to the metallic layer of at least about 200 g/25mm², preferably at least about 400 g/25mm², preferably at least about 600 g/25mm², and preferably at least about 800 g/25mm². Typical bond strengths are in the range of from about 400 to about 1000 g/25mm². The bond strength to the metal should be high enough so that the film destructs if attempts are made to separate the metallic antenna from the polymeric substrate. In one embodiment, the adhesive strength of the substrate to the metallic layer exceeds the Ultimate Tensile Strength (UTS) of the substrate.

The substrate exhibits a low shrinkage, and preferably less than 3% at 190°C over 30 minutes, preferably less than 2%, preferably less than 1%, and preferably less than 0.5%, preferably less than 0.2%.

Formation of the substrate may be effected by conventional techniques well-known in the art. Conveniently, formation of the substrate is effected by extrusion, in accordance with the procedure described below. In general terms the process comprises the steps of extruding a layer of molten polymer, quenching the extrudate and biaxially orienting the quenched extrudate.

The substrate is biaxially oriented by drawing in two mutually perpendicular directions in the plane of the film to achieve a satisfactory combination of mechanical and physical properties. Orientation may be effected by any process known in the art for producing an oriented film, for example a tubular or flat film process. A flat film process may involve either sequential or simultaneous drawing.

In the preferred flat film process, the substrate-forming polyester is melted and extruded through a slot die and rapidly quenched onto a chilled casting drum to ensure that the polyester retains the disordered, amorphous structure of the melt. Orientation on the molecular scale is then effected by reheating the extrudate or cast film above its glass transition temperature (Tg) and stretching it in at least one direction . Typically, stretching will be carried out on film whose temperature has been raised to between 70 and 150°C in the case of polyethylene terephthalate (PET). For polyethylene naphthalate (PEN), higher temperatures are required, typically between 110 and 170°C. As a general rule, the preferred stretching temperatures are in the range of from about (Tg+10°C) to about (Tg+60°C).

Biaxial orientation may be produced by stretching sequentially a flat, quenched extrudate firstly in one direction, usually the longitudinal direction or forward, machine direction (MD) of the process, and then in the transverse direction (TD). Forward stretching of the cast film is conveniently performed over a set of rotating rolls which are driven at different speeds. Although the details of this process step may vary, the principle of the technology, which is to heat and accelerate the cast film in the process direction, is characteristic of all designs. Transverse stretching is then performed in a stenter oven. In the stenter stage of the process, the edges of the film are gripped by clips and led along rails, which provide support during a reheating step and then diverge to cause the material to be stretched for a second time. Alternatively, the cast film may be stretched simultaneously in both the forward and transverse directions in a biaxial stenter. Stretching is performed to an extent determined by the nature of the polyester, for example PET is usually stretched so that the MD and/or TD dimensions of the oriented film are from 2 to 5, more preferably 2.5 to 4.5 times, that of its original dimension. Greater draw ratios (for example, up to about 8 times) may be used if orientation in only one direction is required. It is not necessary to stretch equally in the machine and transverse directions although this is preferred if balanced properties are desired.

In the preferred flat film process, the final stage involves stabilising the stretched film by heat-setting, still at the elevated temperatures of the stenter even and under a controlled dimensional restraint. The film is heated at a temperature above its glass transition temperature but below the melting temperature thereof, to enable crystallisation of the polyester. Some dimensional relaxation (or "toe-in") in either MD or TD or both is permitted at this stage to improve further the final thermal shrinkage or dimensional stability of the finished film. Relaxation of the film in the transverse direction is carried out by converging the paths of the clips holding the film in the stenter. In a sequential stretching process, the relaxation in MD is made possible when the winding speed of the film is lower than its exit speed from the stenter. A simultaneous biaxial stretching process allows for longitudinal (MD) relaxation inside the stenter by the controlled deceleration of the linear motor-driven clips during or after heat-setting so that the speed of the film exiting the stenter oven is slower than the maximum speed within the stenter frame. In applications where dimensional stability is not of significant concern, the film may be heat-set at relatively low temperatures or not at all. In contrast, as the temperature at which the film is heat-set is increased, other properties such as elongation to break and tear-resistance may change. Thus, the actual heat-set temperature and time will be chosen depending on the composition of the film and the balance of final properties desired, as appropriate to the end-use application of the film. Within these constraints, the maximum temperature of the film passing through the heat-set stage of the process will generally be from about 135° to about 250°C , as described in GB-A-838708. The film is then cooled under controlled tension and temperature and wound into rolls.

An optional step in the manufacture of the substrate is to subject it to further heat-stabilisation by heating it under minimal physical restraint at a temperature above the glass transition temperature of the polyester but below the melting point thereof, in order to allow the majority of the inherent shrinkage in the film to occur (relax out) and thereby produce a film with much lower residual shrinkage and consequently higher dimensional stability. The film shrinkage or relaxation which occurs during the further heat-stabilisation stage is effected either by controlling the line tension experienced by the film at elevated temperature or by controlling the line-speed. The tension experienced by the film is a low tension and typically less than 5 kg/m, preferably less than 3.5 kg/m, more preferably in the range of from 1 to about 2.5 kg/m, and typically in the range of 1.5 to 2 kg/m of film width. For a relaxation process which controls the film speed, the reduction in film speed (and therefore the strain relaxation) is typically in the range 0 to 2.5 %, preferably 0.5 to 2.0%. There is no increase in the transverse dimension of the film during the heat-stabilisation step. The temperature to be used for the heat stabilisation step can vary depending on the desired combination of properties from the final film, with a higher temperature giving better, i.e. lower, residual shrinkage properties. A temperature of 135°C to 250°C is generally desirable, preferably 150 to 230°C, more preferably 170 to 200°C. The duration of heating will depend on the temperature used but is typically in the range of 10 to 40 sec, with a duration of 20 to 30 secs being preferred. This heat stabilisation process can be carried out by a variety of methods, including flat and vertical configurations and either "off-line" as a separate process step or "in-line" as a continuation of the film manufacturing process. In one embodiment, heat stabilisation is conducted "off-line". The heat-stabilisation step promotes very low shrinkage, typically less than 1% over 30 minutes in an oven at 190°C, particularly less than 0.5%, and particularly less than 0.2%. The heat-stabilisation step is particularly suitable in the manufacture of coated multilayer substrates such as Embodiments B2 and B4, and would be conducted on the base layer prior to the off-line coating of the heat-sealable layer.

Formation of a multi-layer substrate comprising a heat-sealable layer and a base layer is effected by coextrusion.

In one preferred embodiment, the substrate is a multilayer coextruded substrate comprising a heat-sealable layer and a base layer, according to embodiments B1 and B3. In this embodiment in particular, the thickness of the heat-sealable layer is preferably from about 10 to about 20% of the thickness of the substrate, and preferably up to about 20µm preferably thinner as described herein.

The antenna may be formed on the substrate by a conventional method, for instance according to a method as described hereinabove, and comprises the step of contacting the metallic material of the antenna with a heat-sealable surface of the substrate under conditions of elevated temperature (i.e. at a temperature above room temperature at which the polymeric material of the heat-sealable layer softens to an extent sufficient to adhere the metallic layer), and optionally pressure. In one embodiment, metal wire in a pre-formed configuration may be heat-sealed to the substrate. In a further embodiment, a metallic foil is laminated to a heat-sealable surface of the substrate by contacting the foil with the heat-sealable surface of the substrate under elevated temperature and optionally pressure. The conductive pattern of the antenna is then produced by a conventional technique, such as etching. Techniques for etching conductive patterns onto a substrate are well-known in the art and are disclosed for instance in "The Art of Electronics" by Horowitz and Hill (2nd Edition, 1989, Cambridge University Press; Section 12.04) and also in US-6623844, US- 6621153 and US-2002/015002-A. In one embodiment of an etching process, once the metallic layer has been applied to the substrate, an etching-resist pattern is applied to the metallic layer, for instance by printing a suitable ink on the surface of the metallic layer in the shape of the desired conductive pattern. Any suitable printing technique may be used, for instance gravure printing. The etching-resist ink may need to be cured, for instance by heat or UV irradiation, in order to ensure that it is adhered to the underlying metallic layer sufficiently strongly to withstand the subsequent etching step. Next the substrate/metallic layer/resist pattern laminate is then etched using a suitable reagent to form the desired conductive pattern. For instance, the removal of the exposed portions of a copper layer may be effected using a solution of iron chloride FeCl₂ at around 50°C. The final step in the process is the removal of the material of the resist pattern by a suitable chemical reagent to leave the metallic conductive pattern imprinted on the substrate. In a second embodiment of an etching process, a liquid or dry film resist (such as Riston® from DuPont) is applied in the form of a continuous coating or layer to the metallic layer. A photographic film with a negative image of the conductive pattern (a "photo-tool") is then superposed over the substrate/metallic layer/photo-resist laminate, and the layer of photo-resist is then exposed through the negative using UV light. The exposed areas of the photo-resist are thereby cross-linked or otherwise chemically changed. A developer is then used to remove the unchanged regions of the photo-resist, to leave a protected positive pattern on the copper substrate. The laminate is then etched, and the final step is the removal of the remaining photo-resist to leave the metallic conductive pattern imprinted on the substrate.

The thickness of the conductive metallic pattern is typically between about 2 and 100 µm, and particularly between about 10 and 50 µm, although thicknesses of less than 10 µm are becoming more common.

The antenna may be electrically connected to an optional data-carrying means, such as an integrated circuit, by conventional means, for instance using solder or conductive adhesive. If necessary, the data-carrying means may be affixed to the substrate using additional adhesive (including pressure sensitive adhesive and non-conductive adhesive).

The RF-responsive tag may comprise further optional layers. In RF-responsive tags where an integrated circuit is required to be located substantially over the antenna, an insulating layer may be disposed over at least part of the antenna. A cover layer may be present over the antenna and integrated circuit, and may , be formed from any suitable layer-forming or film-forming material, including the polyester film described herein. The cover may be printable and optionally comprises an ink-receptive layer. The surface of the substrate opposite the surface on which is disposed the antenna may comprise a layer of adhesive, optionally with a cover or release layer that may be peeled away when the RF-responsive tag is to be affixed to an article. In an alternative embodiment, the RF-responsive tag may be affixed to an article by formation of a heat-seal bond. A multilayer substrate comprising a base layer and on a first surface thereof a first heat-sealable layer for bonding to the antenna, as described herein, may comprise a second heat-sealable layer on the second surface thereof for forming a heat-seal bond to an article, wherein the second heat-sealable layer may be the same as or different to the first heat-sealable layer.

According to a further aspect of the present invention, there is provided a method of manufacture of an RF-responsive tag comprising a substrate, an antenna comprising a pattern of conductive material, and optionally a data-carrying means, said method as defined in claim 8.

Where the conductive material of the antenna has not been pre-formed into the conductive pattern of the antenna, step (ii) in the process defined above is the first stage of antenna formation, the second stage of antenna formation being the step of forming a pattern in the conductive material, this second stage being carried out after heat-sealing step the conductive material to the substrate (step (iii) in the process defined above). Formation of the conductive pattern may be effected by a conventional method as described herein, typically by an etching process comprising the steps of forming an etching-resist having a wiring pattern on the surface of the conductive layer, forming a conductive pattern on the surface of the substrate by etching, and removing the resist.

According to a further aspect of the invention, there is provided the use of a heat-sealing film comprising a polyester layer wherein the shrinkage of said film is less than 5% at 190°C over 30 minutes, as described herein, as a substrate in the manufacture of an RF-responsive tag as defined in claim 10.

According to a further aspect of the invention, there is provided a composite film suitable as, or for use as, a precursor in the manufacture of an RF-responsive tag as defined in claim 11.

One or more of the layers of the substrate may conveniently contain any of the additives conventionally employed in the manufacture of polymeric films. Thus, agents such as cross-linking agents, dyes, pigments, voiding agents, lubricants, anti-oxidants, radical scavengers, UV absorbers, thermal stabilisers, anti-blocking agents, surface active agents, slip aids, optical brighteners, gloss improvers, prodegradents, viscosity modifiers and dispersion stabilisers may be incorporated as appropriate. In particular the substrate may comprise a particulate filler which may, for example, be a particulate inorganic filler or an incompatible resin filler or a mixture of two or more such fillers. Such fillers are well-known in the art.

Particulate inorganic fillers include conventional inorganic fillers, and particularly metal or metalloid oxides, such as alumina, silica (especially precipitated or diatomaceous silica and silica gels) and titania, calcined china clay and alkaline metal salts, such as the carbonates and sulphates of calcium and barium. The particulate inorganic fillers may be of the voiding or non-voiding type. Suitable particulate inorganic fillers may be homogeneous and consist essentially of a single filler material or compound, such as titanium dioxide or barium sulphate alone. Alternatively, at least a proportion of the filler may be heterogeneous, the primary filler material being associated with an additional modifying component. For example, the primary filler particle may be treated with a surface modifier, such as a pigment, soap, surfactant coupling agent or other modifier to promote or alter the degree to which the filler is compatible with the polymer layer. Preferred particulate inorganic fillers include titanium dioxide and silica.

The inorganic filler should be finely-divided, and the volume distributed median particle diameter (equivalent spherical diameter corresponding to 50% of the volume of all the particles, read on the cumulative distribution curve relating volume % to the diameter of the particles - often referred to as the "D(v,0.5)" value) thereof is preferably in the range from 0.01 to 5 µm, more preferably 0.05 to 1.5 µm, and particularly 0.15 to 1.2 µm. Preferably at least 90%, more preferably at least 95% by volume of the inorganic filler particles are within the range of the volume distributed median particle diameter ± 0.8 µm, and particularly ± 0.5 µm. Particle size of the filler particles may be measured by electron microscope, coulter counter, sedimentation analysis and static or dynamic light scattering. Techniques based on laser light diffraction are preferred. The median particle size may be determined by plotting a cumulative distribution curve representing the percentage of particle volume below chosen particle sizes and measuring the 50th percentile.

The components of the composition of a layer may be mixed together in a conventional manner For example, by mixing with the monomeric reactants from which the layer polymer is derived, or the components may be mixed with the polymer by tumble or dry blending or by compounding in an extruder, followed by cooling and, usually, comminution into granules or chips. Masterbatching technology may also be employed.

In one embodiment, the substrate is optically clear, preferably having a % of scattered visible light (haze) of <10%, preferably <6%, more preferably <3.5 % and particularly <2%, measured according to the standard ASTM D 1003. Preferably, the total light transmission (TLT) in the range of 400-800 nm is at least 75%, preferably at least 80%, and more preferably at least 85%, measured according to the standard ASTM D 1003. In this embodiment, filler is typically present in only small amounts, generally not exceeding 0.5% and preferably less than 0.2% by weight of the polymer of a given layer.

The following test methods may be used to characterise the polymeric film:
(i) The clarity of the film may be evaluated by measuring total light transmission (TLT) and haze (% of scattered transmitted visible light) through the total thickness of the film using a Gardner XL 211 hazemeter in accordance with ASTM D-1003-61.
(ii) Heat-seal strength of the heat-sealable substrate to itself is measured in an Instron Model 4301 by positioning together and heating the heat-sealable layers of two samples of polyester film at 140°C for one second under a pressure of 43 psi (approx. 296 kPa). The sealed film is cooled to room temperature, and the heat-seal strength determined by measuring the force required under linear tension per unit width of seal to peel the layers of the film apart at a constant speed of 4.23 mm/second.
(iii) Heat-seal strength of the heat-seal bond between the conductive material and the substrate was measured in an Instron Series IX Automated Materials Testing System machine by positioning together and heating the conductive layer and substrate at 140°C for one second under a pressure of 43 psi (approx 296 kPa). The composite film is cooled to room temperature, and the heat-seal strength determined by measuring the force required under linear tension per unit width of seal to peel the layers of the film apart at a constant speed of 50 mm/minute.
(iv) Ultimate tensile strength at destruction (LTTD) and elongation at destruction (ETD) are measured using the ASTM D882-88 test modified as described herein.
(v) Shrinkage at a given temperature is measured by placing the sample, unrestrained, in a heated oven at that temperature for the allotted period of time (typically 30 minutes). The % shrinkage is calculated as the % change of dimension of the film in a given direction before and after heating.
(vi) Flex-cracking can be assessed qualitatively by the repeated bending (through a given angle and about a fulcrum point) of the composite film comprising the heat-sealable substrate and the conductive layer, and assessing by eye whether any cracks have developed in the conductive layer.

The invention is further illustrated by the following examples. It will be appreciated that the examples are for illustrative purposes only and are not intended to limit the invention as described above. Modification of detail may be made without departing from the scope of the invention.

### EXAMPLES

### Example 1

A bi-layer polyester film comprising a substrate layer of clear PET and a copolyester heat-sealable layer was prepared as follows. A polymer composition comprising PET was coextruded with a copolyester comprising terephthalic acid/isophthalic acid/ethylene glycol (82/18/100), cast onto a cooled rotating drum and stretched in the direction of extrusion to approximately 3 times its original dimensions. The film was passed into a stenter oven at a temperature of 100°C where the film was stretched in the sideways direction to approximately 3 times its original dimensions. The biaxially-stretched film was heat-set at a temperature of about 230°C by conventional means. The total thickness of the final film was 23 µm; the heat sealable layer was approximately 4 µm thick.

A copper foil (12 µm) was disposed directly onto the surface of the film by contacting the foil with the heat-sealable surface of the coextruded film and effecting lamination at 140°C for one second under a pressure of 43 psi (about 296 kPa). The heat-seal strength of the metal/film bond was 450 g/25mm².

A pattern was etched in the copper layer according to the techniques described herein by forming an etching-resist having a wiring pattern on the surface of the copper foil by gravure printing, curing the etching-resist ink by UV irradiation, forming a conductor wiring pattern on the surface of the substrate by ferric chloride etching at 50°C, and removing the etching-resist material by dipping the etched film into a sodium hydroxide solution at room temperature.

### Example 2

Example 1 was repeated except that the total thickness of the final film was 75 µm; the heat sealable layer being approximately 11 µm thick. In addition, a copper foil of 20 µm in thickness was laminated to the coextruded film at 160°C for one second under a pressure of 40 psi (about 275 kPa). The heat-seal strength of the metal/film bond was 1323 g/25mm². The shrinkage of the film was 2% in both MD and TD directions.

### Example 3

Example I was repeated except that the total thickness of the final film was 75 µm; the heat sealable layer being approximately 11 µm thick. In addition, an aluminium foil of 13 µm in thickness was laminated to the coextruded film at 160°C for one second under a pressure of 40 psi (about 275 kPa). The heat-seal strength of the metal/film bond was 343g125mm².

### Example 4

Example 1 was repeated except that the total thickness of the final film was 30 µm; the heat sealable layer being approximately 5 µm thick. In addition, a copper foil of 20 µm in thickness was laminated to the coextruded film at 160°C for one second under a pressure of 40 psi (about 275 kPa). The heat-seal strength of the metal/film bond was 537 g/25mm².

### Example 5 .

Example I was repeated except that the total thickness of the final film was 30 µm; the heat sealable layer being approximately 5 µm thick. In addition, an aluminium foil of 13 µm in thickness was laminated to the coextruded film at 160°C for one second under a pressure of 40 psi (about 275 kPa). The heat-seal strength of the metal/film bond was 213g/25mm².

### Example 6

The procedure of Example 1 was repeated using a copolyester of terephthalic acid/1,4-cyclohexane dimethanol/ethylene glycol (100/33/67) as the heat-sealable layer.

## Claims

1. A radio-frequency responsive tag comprising a heat-sealing substrate comprising a polyester layer, and an antenna comprising a pattern of conductive material wherein said conductive material is in direct contact with a heat-sealing surface of the substrate, wherein the shrinkage of the heat-sealing substrate is less than 5% at 190°C over 30 minutes, the % shrinkage being calculated as the % change of dimension of the substrate in a given direction before and after heating, wherein the substrate comprises a heat-sealable layer and a base layer, wherein the base layer comprises polyethylene terephthalate, wherein the heat-sealable layer is a copolyester derived from either: ethylene glycol, terephthalic acid and isophthalic acid; or terephthalic acid, ethylene glycol and 1,4-cyclohexanedimethanol, wherein said substrate is a biaxially oriented heat-set substrate and wherein the heat-sealable layer and base layer are coextruded.

2. A tag according to claim 1 wherein the shrinkage is 3% or less.

3. A tag according to claim 1 or 2, wherein the molar ratio of 1,4-cyclohexanedimethanol to ethylene glycol is in the range from 30:70 to 35:65.

4. A tag according to claim 1 or 2 wherein the copolyester is derived from ethylene glycol, terephthalic acid and isophthalic acid, wherein the molar ratio of the terephthalic acid component to the isophthalic acid component is in the range from 65:35 to 85:15.

5. A tag according to any preceding claim wherein the conductive material comprises a metallic material.

6. A tag according to any preceding claim wherein the conductive material comprises copper.

7. A tag according to any preceding claim which further comprises a data-carrying means in electrical communication with the antenna.

8. A method of manufacture of a radio-frequency responsive tag comprising a substrate, an antenna comprising a pattern of conductive material, and optionally a data-carrying means, said method comprising the following steps:
(i) providing a heat-sealable substrate comprising a polyester layer wherein the shrinkage of said substrate is less than 5% at 190°C over 30 minutes wherein the percentage shrinkage is calculated as the percentage change of dimension of the substrate in a given direction before and after heating, wherein the substrate comprises a heat-sealable layer and a base layer, wherein the base layer comprises polyethylene terephthalate, wherein the heat-sealable layer is a copolyester derived from terephthalic acid, ethylene glycol and 1,4-cyclohexanedimethanol or ethylene glycol, terephthalic acid and isophthalic acid, wherein the heat-sealable layer and base layer are coextruded and wherein said substrate is a biaxially oriented heat set substrate;
(ii) disposing the conductive material of the antenna directly onto at least part of a heat-sealable surface of the substrate;
(iii) effecting heat-sealing between the heat-sealable substrate and the conductive material;
(iv) optionally providing a data-carrying means in electrical communication with the conductive material.

9. A method according to claim 8 wherein the method further comprises, subsequent to step (iii), formation of a pattern in the conductive material

10. Use of a heat-sealing film comprising a polyester layer wherein the shrinkage of said film is less than 5% at 190°C over 30 minutes as a substrate in the manufacture of a radio-frequency responsive tag comprising said film as a substrate, an antenna comprising a pattern of conductive material, and optionally a data-carrying means in electrical communication with the antenna, wherein the conductive material is in direct contact with a heat-sealing surface of the film, wherein the percentage shrinkage is calculated as the percentage change of dimension of the substrate in a given direction before and after heating, wherein the substrate comprises a heat-sealable layer and a base layer, wherein the base layer comprises polyethylene terephthalate, wherein the heat-sealable layer is a copolyester derived from terephthalic acid, ethylene glycol and 1,4-cyclohexanedimethanol or ethylene glycol, terephthalic acid and isophthalic acid, wherein the heat-sealable layer and base layer are coextruded and wherein said substrate is a biaxially oriented heat set substrate.

11. A composite film suitable for use as a precursor in the manufacture of a radio-frequency responsive tag, said composite film comprising a layer of conductive material and a heat-sealing substrate comprising a polyester layer wherein the shrinkage of the heat-sealing substrate is less than 5% at 190°C over 30 minutes, the percentage shrinkage being calculated as the percentage change of dimension of the substrate in a given direction before and after heating, wherein the conductive material is in direct contact with a heat-sealing surface of the substrate, wherein the substrate comprises a heat-sealable layer and a base layer, wherein the base layer comprises polyethylene terephthalete, wherein the heat-sealable layer is a copolyester derived from either ethylene glycol, terephthalic acid and isophthalic acid, or terephthalic acid, ethylene glycol and 1,4-cyclohexanedimethanol, wherein the heat-sealable layer and base layer are coextruded and wherein the substrate is a biaxially oriented heat-set substrate, and the conductive material is suitable for the manufacture of the antenna of said tag.

12. A composite film according to claim 11 wherein the heat-seal bond strength between the conductive material and the substrate is at least 200g/25mm².

## Patentansprüche

1. Radiofrequenz ansprechendes Etikett, umfassend ein heiß versiegelndes Substrat, umfassend eine Polyesterschicht, und eine Antenne, umfassend ein Muster von leitfähigem Material, wobei das leitfähige Material in direktem Kontakt mit einer heiß versiegelnden Oberfläche des Substrats ist, wobei die Schrumpfung des heiß versiegelnden Substrats weniger als 5% bei 190°C über 30 Minuten beträgt, wobei der Prozentwert bezüglich der Schrumpfung berechnet wird als die Dimensionsänderung in % des Substrats in einer gegebenen Richtung vor und nach dem Erhitzen, wobei das Substrat eine heiß versiegelbare Schicht und eine Grundschicht umfaßt, wobei die Grundschicht Polyethylenterephthalat umfaßt, wobei die heiß versiegelbare Schicht ein Copolyester ist, abgeleitet von entweder: Ethylenglykol, Terephthalsäure und Isophthalsäure, oder Terephthalsäure, Ethylenglykol und 1,4-Cyclohexandimethanol, wobei das Substrat ein biaxial orientiertes wärmegehärtetes Substrat ist, und wobei die heiß versiegelbare Schicht und die Grundschicht coextrudiert sind.

2. Etikett gemäß Anspruch 1, wobei die Schrumpfung 3% oder weniger ist.

3. Etikett gemäß Anspruch 1 oder 2, wobei das Molverhältnis von 1,4-Cyclohexandimethanol zu Ethylenglykol in dem Bereich von 30:70 bis 35:65 ist.

4. Etikett gemäß Anspruch 1 oder 2, wobei der Copolyester von Ethylenglykol, Terephthalsäure und Isophthalsäure abgeleitet ist, wobei das Molverhältnis der Terephthalsäurekomponente zu der Isophthalsäurekomponente in dem Bereich von 65:35 bis 85:15 ist.

5. Etikett gemäß einem vorhergehenden Anspruch, wobei das leitfähige Material ein metallisches Material umfaßt.

6. Etikett gemäß einem vorhergehenden Anspruch, wobei das leitfähige Material Kupfer umfaßt.

7. Etikett gemäß einem vorhergehenden Anspruch, welches weiter ein Daten tragendes Mittel in elektrischer Verbindung mit der Antenne umfaßt.

8. Verfahren zur Herstellung eines Radiofrequenz-ansprechenden Etiketts, umfassend ein Substrat, eine Antenne, umfassend ein Muster von leitfähigem Material und gegebenenfalls ein Daten tragendes Mittel, wobei das Verfahren die folgenden Schritte umfaßt:
(i) das Bereitstellen eines heiß versiegelbaren Substrats, umfassend eine Polyesterschicht, wobei die Schrumpfung des Substrats weniger als 5% bei 190°C über 30 Minuten beträgt, wobei der Prozentwert der Schrumpfung berechnet wird als der Prozentwert der Dimensionsänderung des Substrats in einer gegebenen Richtung vor und nach dem Erwärmen, wobei das Substrat eine heiß versiegelbare Schicht und eine Grundschicht umfaßt, wobei die Grundschicht Polyethylenterephthalat umfaßt, wobei die heiß versiegelbare Schicht ein Copolyester ist, abgeleitet von Terephthalsäure, Ethylenglykol und 1,4-Cyclohexandimethanol oder Ethylenglykol, Terephthalsäure und Isophthalsäure, wobei die heiß versiegelbare Schicht und die Grundschicht coextrudiert werden, und wobei das Substrat ein biaxial orientiertes wärmegehärtetes Substrat ist,
(ii) das Anordnen des leitfähigen Materials der Antenne direkt auf mindestens einem Teil der heiß versiegelbaren Oberfläche des Substrats,
(iii) das Bewirken des Heißversiegelns zwischen dem heiß versiegelbaren Substrat und dem leitfähigen Material,
(iv) gegebenenfalls das Anordnen eines Daten tragenden Mittels in elektrischer Verbindung mit dem leitfähigen Material.

9. Verfahren gemäß Anspruch 8, wobei das Verfahren nach dem Schritt (iii) foldie Bildung eines Musters in dem leitfähigen Material umfaßt.

10. Verwendung einer heiß versiegelnden Folie, umfassend eine Polyesterschicht, wobei die Schrumpfung der Folie weniger als 5% bei 190°C über 30 Minuten beträgt, als ein Substrat in der Herstellung eines Radiofrequenz-ansprechenden Etiketts, umfassend die Folie als ein Substrat, eine Antenne, umfassend ein Muster von leitfähigem Material, und gegebenenfalls ein Daten tragendes Mittel in elektrischer Verbindung mit der Antenne, wobei das leitfähige Material in direktem Kontakt mit einer heiß versiegelnden Oberfläche der Folie ist, wobei der Prozentwert der Schrumpfung berechnet wird als der Prozentwert der Dimensionsänderung des Substrats in einer gegebenen Richtung vor und nach dem Erwärmen, wobei das Substrat eine heiß versiegelbare Schicht und eine Grundschicht umfaßt, wobei die Grundschicht Polyethylenterephthalat umfaßt, wobei die heiß versiegelbare Schicht ein Copolyester ist, abgeleitet von Terephthalsäure, Ethylenglykol und 1,4-Cyclohexandimethanol oder Ethylenglykol, Terephthalsäure und Isophthalsäure, wobei die heiß versiegelbare Schicht und Grundschicht coextrudiert werden, und wobei das Substrat ein biaxial orientiertes wärmegehärtetes Substrat ist.

11. Kompositfolie, geeignet zur Verwendung als ein Vorläufer in der Herstellung eines Radiofrequenz-ansprechenden Etiketts, wobei die Kompositfolie eine Schicht von leitfähigem Material und ein heiß versiegelndes Substrat, umfassend eine Polyesterschicht, umfaßt, wobei die Schrumpfung des heiß versiegelnden Substrats weniger als 5% bei 190°C über 30 Minuten beträgt, wobei der Prozentwert der Schrumpfung berechnet wird als der Prozentwert der Dimensionsänderung des Substrats in einer gegebenen Richtung vor und nach dem Erwärmen, wobei das leitfähige Material in direktem Kontakt mit einer heiß versiegelnden Oberfläche des Substrats ist, wobei das Substrat eine heiß versiegelbare Schicht und eine Grundschicht umfaßt, wobei die Grundschicht Polyethylenterephthalat umfaßt, wobei die heiß versiegelbare Schicht ein Copolyester ist, abgeleitet von entweder Ethylenglykol, Terephthalsäure und Isophthalsäure oder Terephthalsäure, Ethylenglykol und 1,4-Cyclohexandimethanol, wobei die heiß versiegelbare Schicht und Grundschicht coextrudiert sind, und wobei das Substrat ein biaxial orientiertes wärmegehärtetes Substrat ist, und das leitfähige Material zur Herstellung der Antenne des Etiketts geeignet ist.

12. Kompositfolie gemäß Anspruch 11, wobei die Heißsiegelbindungsfestigkeit zwischen dem leitfähigen Material und dem Substrat mindestens 200 g/25 mm² beträgt.

## Revendications

1. Etiquette sensible aux radiofréquences comprenant un substrat thermoscellable comprenant une couche de polyester, et une antenne comprenant un motif en matériau conducteur dans laquelle ledit matériau conducteur est en contact direct avec une surface thermoscellable du substrat, dans laquelle le retrait du substrat thermoscellable est inférieur à 5 % à 190 °C au delà de 30 minutes, le % de retrait correspondant au % de variation de dimension du substrat dans une direction donnée avant et après chauffage, dans laquelle le substrat comprend une couche thermoscellable et une couche de base, dans laquelle la couche de base comprend du polyéthylène térephtalate, dans laquelle la couche thermoscellable est un copolyester dérivé de l'éthylène glycol, de l'acide térephtalique et de l'acide isophtalique, ou de l'acide térephtalique, de l'éthylène glycol et du 1,4-cyclohexanediméthanol, dans laquelle ledit substrat est un substrat thermofixé bi-orienté et dans laquelle la couche thermoscellable et la couche de base sont coextrudées.

2. Etiquette selon la revendication 1, dans laquelle le retrait est de 3 % ou moins.

3. Etiquette selon la revendication 1 ou 2, dans laquelle le rapport molaire du 1,4-cyclohexanediméthanol à l'éthylène glycol se situe dans la plage de 30/70 à 35/65.

4. Etiquette selon la revendication 1 ou 2, dans laquelle le copolyester est dérivé de l'éthylène glycol, de l'acide térephtalique et de l'acide isophtalique, dans laquelle le rapport molaire du composant acide térephtalique au composant acide isophtalique se situe dans la plage de 65/35 à 85/15.

5. Etiquette selon l'une quelconque des revendications précédentes, dans laquelle le matériau conducteur comprend un matériau métallique.

6. Etiquette selon l'une quelconque des revendications précédentes, dans laquelle le matériau conducteur comprend du cuivre.

7. Etiquette selon l'une quelconque des revendications précédentes, laquelle comprend en outre un moyen porteur de données en communication électrique avec l'antenne.

8. Procédé de fabrication d'une étiquette sensible aux radiofréquences comprenant un substrat, une antenne comprenant un motif en matériau conducteur et, facultativement, un moyen porteur de données, ledit procédé comprenant les étapes suivantes consistant à :
(i) fournir un substrat thermoscellable comprenant une couche de polyester dans lequel le retrait dudit substrat est inférieur à 5 % à 190 °C au delà de 30 minutes, le pourcentage de retrait correspondant au pourcentage de variation de dimension du substrat dans une direction donnée avant et après chauffage, dans lequel le substrat comprend une couche thermoscellable et une couche de base, dans lequel la couche de base comprend du polyéthylène térephtalate, dans lequel la couche thermoscellable est un copolyester dérivé de l'acide térephtalique, de l'éthylène glycol et du 1,4-cyclohexanediméthanol, ou de l'éthylène glycol, de l'acide térephtalique et de l'acide isophtalique, dans lequel la couche thermoscellable et la couche de base sont coextrudées et dans lequel ledit substrat est un substrat thermofixé bi-orienté ;
(ii) disposer le matériau conducteur de l'antenne directement sur au moins une partie d'une surface thermoscellable du substrat ;
(iii) effectuer le thermocollage entre le substrat thermoscellable et le matériau conducteur ;
(iv) facultativement, fournir un moyen porteur de données en communication électrique avec le matériau conducteur.

9. Procédé selon la revendication 8, dans lequel le procédé comprend en outre, après l'étape (iii), la formation d'un motif dans le matériau conducteur.

10. Utilisation d'un film thermoscellable comprenant une couche de polyester dans lequel le retrait dudit film est inférieur à 5 % à 190 °C au delà de 30 minutes comme substrat dans la fabrication d'une étiquette sensible aux radiofréquences comprenant ledit film en tant que substrat, une antenne comprenant un motif en matériau conducteur et, facultativement, un moyen porteur de données en communication électrique avec l'antenne, dans laquelle le matériau conducteur est en contact direct avec une surface thermoscellable du film, dans laquelle le pourcentage de retrait correspond au pourcentage de variation de dimension du substrat dans une direction donnée avant et après chauffage, dans laquelle le substrat comprend une couche thermoscellable et une couche de base, dans laquelle la couche de base comprend du polyéthylène térephtalate, dans laquelle la couche thermoscellable est un copolyester dérivé de l'acide térephtalique, de l'éthylène glycol et du 1,4-cyclohexanediméthanol, ou de l'éthylène glycol, de l'acide térephtalique et de l'acide isophtalique, dans laquelle la couche thermoscellable et la couche de base sont coextrudées et dans laquelle ledit substrat est un substrat thermofixé bi-orienté.

11. Film composite destiné à être utilisé comme précurseur dans la fabrication d'une étiquette sensible aux radiofréquences, ledit film composite comprenant une couche de matériau conducteur et un substrat thermoscellable comprenant une couche de polyester dans lequel le retrait du substrat thermoscellable est inférieur à 5 % à 190 °C au delà de 30 minutes, le pourcentage de retrait correspondant au pourcentage de variation de dimension du substrat dans une direction donnée avant et après chauffage, dans lequel le matériau conducteur est en contact direct avec une surface thermoscellable du substrat, dans lequel le substrat comprend une couche thermoscellable et une couche de base, dans lequel la couche de base comprend du polyéthylène térephtalate, dans lequel la couche thermoscellable est un copolyester dérivé de l'éthylène glycol, de l'acide térephtalique et de l'acide isophtalique, ou de l'acide térephtalique, de l'éthylène glycol et du 1,4-cyclohexanediméthanol, dans lequel la couche thermoscellable et la couche de base sont coextrudées et dans lequel ledit substrat est un substrat thermofixé bi-orienté, et le matériau conducteur convient à la fabrication de l'antenne de ladite étiquette.

12. Film composite selon la revendication 11, dans lequel la résistance d'adhésion du thermoscellement entre le matériau conducteur et le substrat est d'au moins 200 g/25 mm².
